# EUROPEAN PATENT APPLICATION

(11) **EP 4 654 809 A1**
(43) Date of publication of application: **26.11.2025**
(21) Application number: 23917571.4
(22) Date of filing: 20.01.2023
(51) Int. Cl.: H10N 60/12, H01L 21/3205, H01L 21/768, H01L 23/522, H10N 60/00, H10N 60/01, H10N 60/80

(54) **DEVICE AND METHOD FOR MANUFACTURING DEVICE**

(71) Applicant: FUJITSU LIMITED, Kawasaki-shi, Kanagawa 211-8588 (JP)
(72) Inventor: NAKAMURA, Makoto, Kawasaki-shi, Kanagawa 211-8588 (JP)
(74) Representative: Haseltine Lake Kempner LLP
(86) International application number: PCT/JP2023/001780
(87) International publication number: WO 2024/154358

(57) **Abstract**

A device includes a substrate including a first surface, a second surface opposite to the first surface, and a through hole penetrating between the first surface and the second surface, a through electrode provided in the through hole, the through electrode having a side portion along an inner wall surface of the through hole and a bottom portion connected to the side portion, a protective film provided closer to a center of the through electrode than the through hole, and a first wiring provided on the second surface of the substrate and connected to the bottom portion of the through electrode.

## Description

### [Technical Field]

The present invention relates to a device and a method of manufacturing a device.

### [Background Art]

There has been known an interposer that is a relay substrate for providing conduction between front and back circuits by means of a through electrode. For example, there has been known that a quantum bit chip is flip-chip mounted on the interposer (for example, Patent Literatures 1 to 3). Further, there has been known a configuration in which a quantum bit and a passive element provided on the front and back surfaces of a substrate are connected by a through electrode (for example, Patent Literature 4).

### [Citation List]

### [Patent Literature]

Patent Literature 1: International Publication Pamphlet No. WO2021/245949
Patent Literature 2: International Publication Pamphlet No. WO2018/212041
Patent Literature 3: U.S. Patent application Publication No. 2022/0199507
Patent Literature 4: U.S. Patent application Publication No. 2020/0343434

### [Summary of Invention]

### [Technical Problem]

When the through electrode is provided so as to fill the through hole penetrating the substrate, the substrate and/or the through electrode may be damaged due to a difference in linear expansion coefficient between the substrate and the through electrode. Therefore, in order to reduce the volume of the through electrode, the through electrode may be formed in a cylindrical shape along the inner wall surface of the through hole. However, in this case, a connection area between the wiring formed on the substrate and the through electrode is reduced, and the contact between the wiring and the through electrode may become unstable.

In one aspect, the object is to increase the connection area between the through electrode and the wiring.

### [Solution to Problem]

In one aspect, there is provided a device including a substrate including a first surface, a second surface opposite to the first surface, and a through hole penetrating between the first surface and the second surface, a through electrode provided in the through hole, the through electrode having a side portion along an inner wall surface of the through hole and a bottom portion connected to the side portion, a protective film provided closer to a center of the through electrode than the through hole, and a first wiring provided on the second surface of the substrate and connected to the bottom portion of the through electrode.

In one aspect, there is provided a method of manufacturing a device including a step of forming a through electrode in a through hole penetrating between a first surface of a substrate and a second surface opposite to the first surface, the through electrode having a side portion along an inner wall surface of the through hole and a bottom portion connected to the side portion, a step of forming a protective film at a position closer to a center of the through electrode than the through hole, and a step of forming a first wiring connected to the bottom of the through electrode on the second surface of the substrate.

### [Advantageous Effects of Invention]

As one aspect, the connection area between the through electrode and the wiring can be increased.

### [Brief Description of Drawings]

[FIG. 1] FIG. 1 is a cross-sectional view of a device according to a first embodiment.
[FIG. 2] FIG. 2(a) is a plan view of the through electrode as viewed from a +Z direction in the first embodiment, and FIG. 2(b) is a plan view of the through electrode as viewed from a -Z direction in the first embodiment.
[FIG. 3] FIGs. 3(a) to 3(c) are cross-sectional views (Part 1) illustrating a method of manufacturing a device according to the first embodiment.
[FIG. 4] FIGs. 4(a) to 4(c) are cross-sectional views (Part 2) illustrating the method of manufacturing the device according to the first embodiment.
[FIG. 5] FIGs. 5(a) to 5(c) are cross-sectional views (Part 3) illustrating the method of manufacturing the device according to the first embodiment.
[FIG. 6] FIGs. 6(a) to 6(c) are cross-sectional views (Part 4) illustrating the method of manufacturing the device according to the first embodiment.
[FIG. 7] FIGs. 7(a) to 7(c) are cross-sectional views (Part 5) illustrating the method of manufacturing the device according to the first embodiment.
[FIG. 8] FIGs. 8(a) to 8(c) are cross-sectional views (Part 1) illustrating a method of manufacturing a device according to a first comparative example.
[FIG. 9] FIGs. 9(a) to 9(c) are cross-sectional views (Part 2) illustrating the method of manufacturing the device according to the first comparative example.
[FIG. 10] FIGs. 10(a) and 10(b) are cross-sectional views illustrating an example in which a cavity is not formed in the through hole in the first embodiment.
[FIG. 11] FIG. 11(a) is a cross-sectional view of a device according to a second embodiment, and FIG. 11(b) is a cross-sectional view of a device according to a modification of the second embodiment.
[FIG. 12] FIG. 12 is a cross-sectional view of a device according to a third embodiment.
[FIG. 13] FIG. 13(a) is a plan view of a quantum bit element according to the third embodiment, and FIG. 13(b) is a cross-sectional view taken along a line A-A in FIG. 13(a).
[FIG. 14] FIGs. 14(a) to 14(c) are cross-sectional views (Part 1) illustrating a method of manufacturing the device according to the third embodiment.
[FIG. 15] FIGs. 15(a) to 15(c) are cross-sectional views (Part 2) illustrating a method of manufacturing the device according to the third embodiment.
[FIG. 16] FIGs. 16(a) to 16(c) are cross-sectional views (Part 1) illustrating a method of manufacturing a quantum bit element and a third wiring pattern according to the third embodiment.
[FIG. 17] FIGs. 17(a) to 17(c) are cross-sectional views (Part 2) illustrating a method of manufacturing the quantum bit element and the third wiring pattern according to the third embodiment.
[FIG. 18] FIG. 18 is a cross-sectional view of a device according to a modification of the third embodiment.
[FIG. 19] FIGs. 19(a) to 19(c) are cross-sectional views illustrating a method of manufacturing the device according to the modification of the third embodiment.
[FIG. 20] FIGs. 20(a) to 20(c) are cross-sectional views (Part 1) illustrating a method of manufacturing a device according to a second comparative example.
[FIG. 21] FIGs. 21(a) to 21(c) are cross-sectional views (Part 2) illustrating a method of manufacturing the device according to the second comparative example.
[FIG. 22] FIG. 22(a) is a cross-sectional view of a device according to a fourth embodiment, and FIG. 22(b) is a cross-sectional view of a device according to a modification of the fourth embodiment.

### [Description of Embodiments]

Hereinafter, embodiments of the present disclosure will be described with reference to the drawings.

### [First Embodiment]

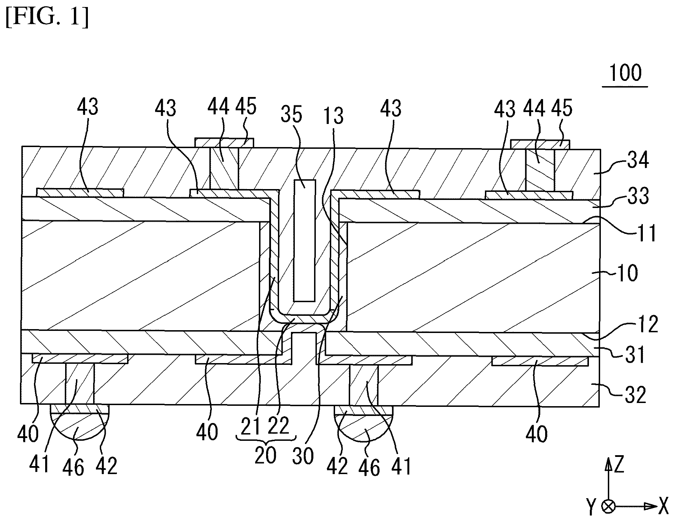

FIG. 1 is a cross-sectional view of a device according to a first embodiment. The first embodiment indicates an example in which a device 100 is an interposer. Directions parallel to a first surface 11 of a substrate 10 and perpendicular to each other are defined as an X-axis and a Y-axis, and the thickness direction of the substrate 10 is defined as a Z-axis. As illustrated in FIG. 1, in the device 100 according to the first embodiment, a through hole 13 penetrating between the first surface 11 and a second surface 12 is formed in the substrate 10 having the first surface 11 and the second surface 12 opposite to the first surface 11. The substrate 10 is, for example, a silicon substrate, a glass substrate, or a quartz substrate. The through hole 13 has a diameter of, for example, about 5 µm to 15 µm and a depth of about 100 µm to 300 µm.

A through electrode 20 is provided in the through hole 13. The through electrode 20 has a cylindrical side portion 21 extending along the inner wall surface of the through hole 13, and a bottom portion 22 which is connected to the end of the side portion 21 and is a plate-like portion provided so as to overlap the inside of the cylindrical shape of the side portion 21 in plan view. An insulating film 30 is provided between the inner wall surface of the through hole 13 and the through electrode 20. The through electrode 20 is formed of, for example, titanium nitride, and has a thickness of, for example, about 50 nm to 150 nm. The insulating film 30 is formed of, for example, silicon oxide and has a thickness of, for example, 50 nm to 150 nm.

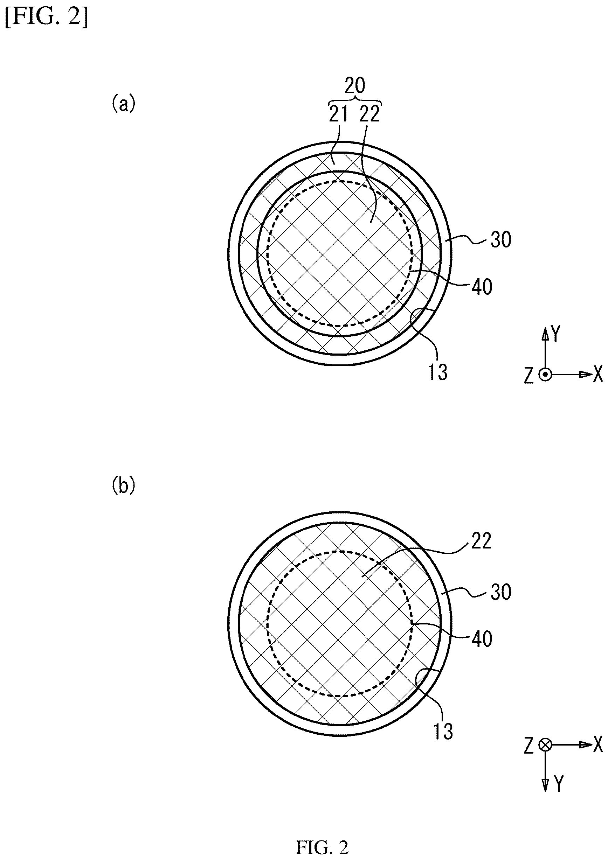

FIG. 2(a) is a plan view of the through electrode as viewed from a +Z direction in the first embodiment, and FIG. 2(b) is a plan view of the through electrode as viewed from a-Z direction in the first embodiment. In FIGs. 2(a) and 2(b), the through electrode 20 is hatched for the sake of clarity. As illustrated in FIGs. 2(a) and 2(b), the side portion 21 of the through electrode 20 is formed in a cylindrical shape along the inner wall surface of the through hole 13. The bottom portion 22 is connected to an end of the side portion 21 and covers the cylindrical interior of the side portion 21. Therefore, the through electrode 20 has a concave shape.

As illustrated in FIG. 1, one or a plurality of first wiring patterns 40 are provided on the second surface 12 of the substrate 10 via an insulating film 31. The first wiring pattern 40, which overlaps the through hole 13, of the one or the plurality of first wiring patterns 40 enters the opening provided in the insulating film 31 and the insulating film 30 and is connected to the bottom 22 of the through electrode 20. In FIGs. 2(a) and 2(b), a range in which the first wiring pattern 40 is in contact with the bottom portion 22 is illustrated by a dotted line. The first wiring pattern 40 is in contact with a region of a half or more of the surface (a hatched portion in FIG. 2(b)) near the first wiring pattern 40 of the bottom portion 22. The first wiring pattern 40 is formed of, for example, titanium nitride, and has a thickness of, for example, 50 nm to 150 nm. The insulating film 31 is formed of, for example, silicon oxide and has a thickness of, for example, about 50 nm to 150 nm.

An insulating film 32 covering the one or the plurality of first wiring patterns 40 is provided on the second surface 12 of the substrate 10. Through wirings 41 are provided which are embedded in openings provided in the insulating film 32 and connected to the first wiring patterns 40. First terminal electrodes 42 connected to the through wirings 41 and serving as terminals for external connection are provided on the insulating film 32. Bump electrodes 46 are provided on the surfaces of the first terminal electrodes 42. The insulating film 32 is formed of, for example, silicon oxide, and has a thickness of, for example, 100 nm to 300 nm. The first terminal electrode 42 is formed of a high-melting-point metal material such as vanadium, molybdenum, hafnium, or tantalum. The through wirings 41 may be formed of the same material as the first terminal electrode 42 or a different material from the first terminal electrode 42. The bump electrodes 46 are formed of, for example, indium, gallium, or solder.

One or a plurality of second wiring patterns 43 are provided on the first surface 11 of the substrate 10 via an insulating film 33. At least a part of the one or the plurality of second wiring patterns 43 is provided so as to extend from the side portion 21 of the through electrode 20. An insulating film 34 covering the one or the plurality of second wiring patterns 43 is provided on the first surface 11 of the substrate 10. A part of the insulating film 34 enters the through hole 13 and covers the surface of the side portion 21 and the bottom portion 22 of the through electrode 20. A cavity 35 is formed inside the insulating film 34 of the through hole 13. By covering the through electrode 20 with the insulating film 34, the through electrode 20 is protected and the occurrence of unintended conduction is suppressed. Through wirings 44 are provided which is embedded in openings provided in the insulating film 34 and connected to the second wiring patterns 43. Second terminal electrodes 45 connected to the through wirings 44 and serving as terminals for external connection are provided on the insulating film 34.

The second wiring patterns 43 are formed of, for example, titanium nitride, and have thicknesses of, for example, 50 nm to 150 nm. The insulating film 33 is formed of, for example, silicon oxide, and has a thickness of, for example, about 50 nm to 150 nm. The insulating film 34 is formed of, for example, silicon oxide, and has a thickness of, for example, 100 nm to 300 nm. The second terminal electrodes 45 are formed of a high-melting-point metal material, as in the case of the first terminal electrodes 42. The through wirings 44 may be formed of the same material as the second terminal electrode 45 or may be formed of a different material from the second terminal electrode 45.

As described above, the insulating film 34 provided closer to the center of the through hole 13 than the through electrode 20 is formed of, for example, silicon oxide. The through electrode 20 is formed of, for example, titanium nitride. The substrate 10 is formed of, for example, silicon. The linear expansion coefficient of silicon oxide is 0.5 × 10⁻⁶/K, the linear expansion coefficient of titanium nitride is 9.35 × 10⁻⁶/K, and the linear expansion coefficient of silicon is 3.9 × 10⁻⁶/K. Therefore, the insulating film 34 provided closer to the center of the through hole 13 than the through electrode 20 has a linear expansion coefficient closer to the linear expansion coefficient of the substrate 10 than the linear expansion coefficient of the through electrode 20.

When the quantum bit chip is mounted on the device 100, it is preferable that the electrodes and the wirings are formed of a superconducting material exhibiting superconductivity at a cryogenic temperature (for example, 10 Kelvin or less). That is, the through electrode 20, the first wiring patterns 40, the second wiring patterns 43, the first terminal electrodes 42, the second terminal electrodes 45, the through wirings 41 and 44, and the bump electrodes 46 are preferably formed of a superconducting material. Examples of the superconducting material include aluminum, titanium, vanadium, zinc, gallium, zirconium, niobium, molybdenum, technetium, cadmium, indium, tin, hafnium, tantalum, niobium nitride, and titanium nitride. When a chip other than the quantum bit chip is mounted on the device 100, the electrodes and the wirings may be formed of copper, tungsten, or the like in addition to the above-described materials.

### [Manufacturing Method]

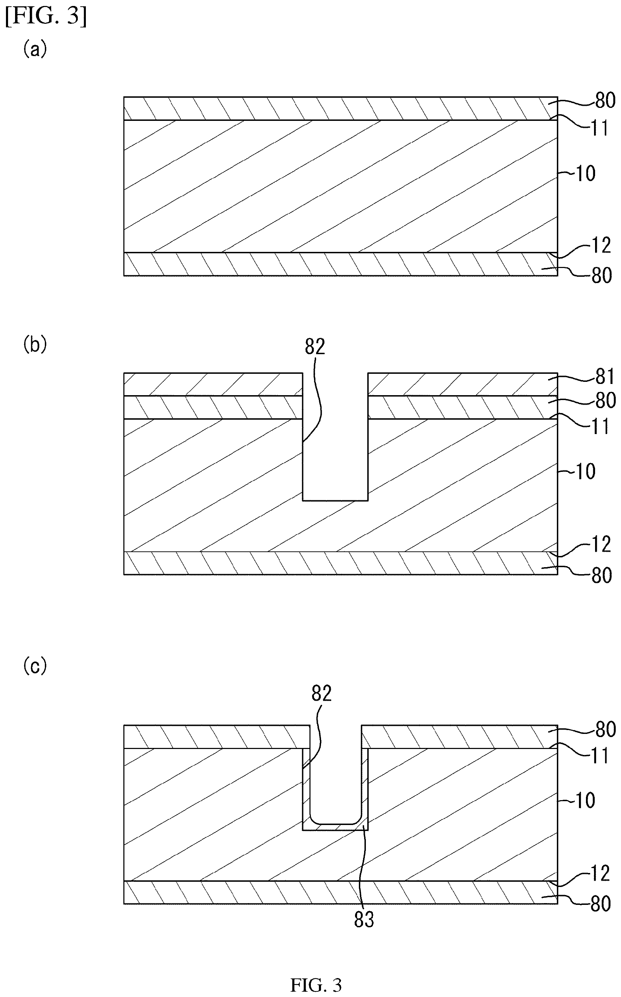

FIGs. 3(a) to 7(c) are cross-sectional views illustrating a method of manufacturing a device according to the first embodiment. As illustrated in FIG. 3(a), after cleaning the substrate 10 which is a silicon substrate, the substrate 10 is heated in an oxidizing atmosphere to form a thermal oxide film 80 which is a silicon oxide film on the first surface 11 and the second surface 12 of the substrate 10. The thickness of the thermal oxide film 80 is 100 nm as an example.

As illustrated in FIG. 3(b), a resist film 81 is formed by applying a resist onto the thermal oxide film 80 formed on the first surface 11 of the substrate 10. The resist film 81 is exposed and developed to form an opening in the resist film 81. A hard mask layer may be formed between the resist film 81 and the thermal oxide film 80. By using the resist film 81 as a mask, a recess 82 is formed in the substrate 10. The recess 82 is formed by using, for example, a Bosch process. The recess 82 corresponds to the through hole 13 in FIG. 1, and has a diameter of, for example, 10 µm and a depth of, for example, 200 µm.

As illustrated in FIG. 3(c), after the resist film 81 is removed and the substrate 10 is cleaned, the substrate 10 is heated in an oxidizing atmosphere to form a thermal oxide film 83, which is a silicon oxide film, on the inner surface of the recess 82. The thickness of the thermal oxide film 83 is 50 nm as an example.

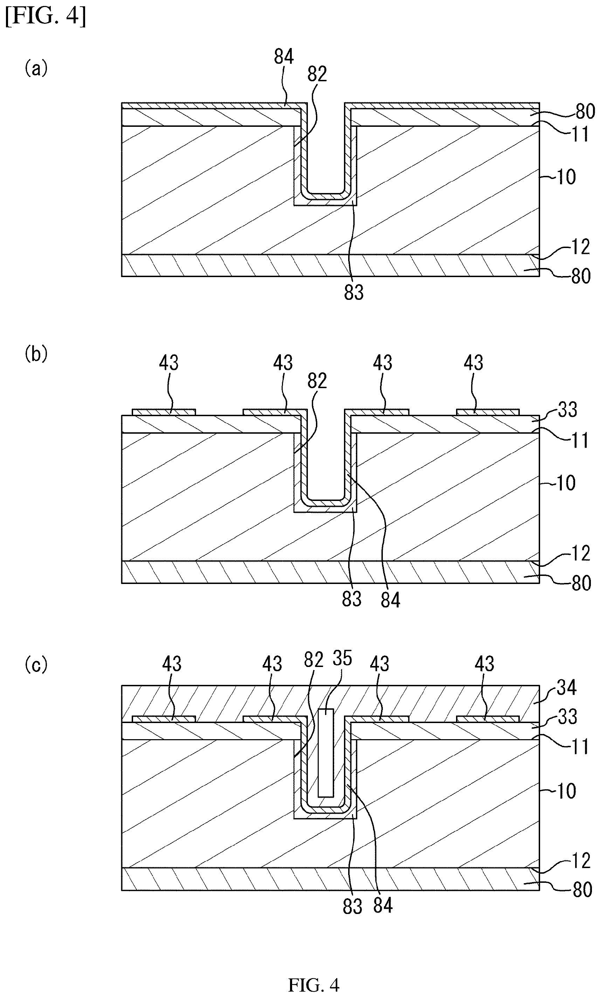

As illustrated in FIG. 4(a), a conductive film 84 made of, for example, titanium nitride is formed on the first surface 11 of the substrate 10 by, for example, an atomic layer deposition (ALD) method. For example, the conductive film 84 made of titanium nitride is formed by an ALD method using Ti[N(CH₃)₂]₄ gas and NH₃ gas. The thickness of the conductive film 84 is 100 nm as an example. N₂H₄ gas may be used instead of NH₃ gas. The conductive film 84 is formed along the surface of the thermal oxide film 80 and the surface of the thermal oxide film 83 formed on the inner surface of the recess 82. The recess 82 is not filled with the conductive film 84, and a cavity is formed inside the conductive film 84.

As illustrated in FIG. 4(b), the conductive film 84 is patterned by reactive ion etching (RIE) using, for example, a chlorine-based gas. Thus, one or a plurality of second wiring patterns 43 made of the conductive film 84 are formed. The second wiring patterns 43 are formed on the first surface 11 of the substrate 10 through the insulating film 33 made of the thermal oxide film 80.

As illustrated in FIG. 4(c), the insulating film 34 made of a silicon oxide film is formed on the first surface 11 of the substrate 10 by, for example, a chemical vapor deposition (CVD) method. The thickness of the insulating film 34 is 200 nm as an example. The insulating film 34 is formed on the insulating film 33 so as to cover the second wiring patterns 43, and also covers the surface of the conductive film 84 formed along the side surface and the bottom surface of the recess 82. The recess 82 is not filled with, for example, the insulating film 34, and the cavity 35 is formed inside the insulating film 34.

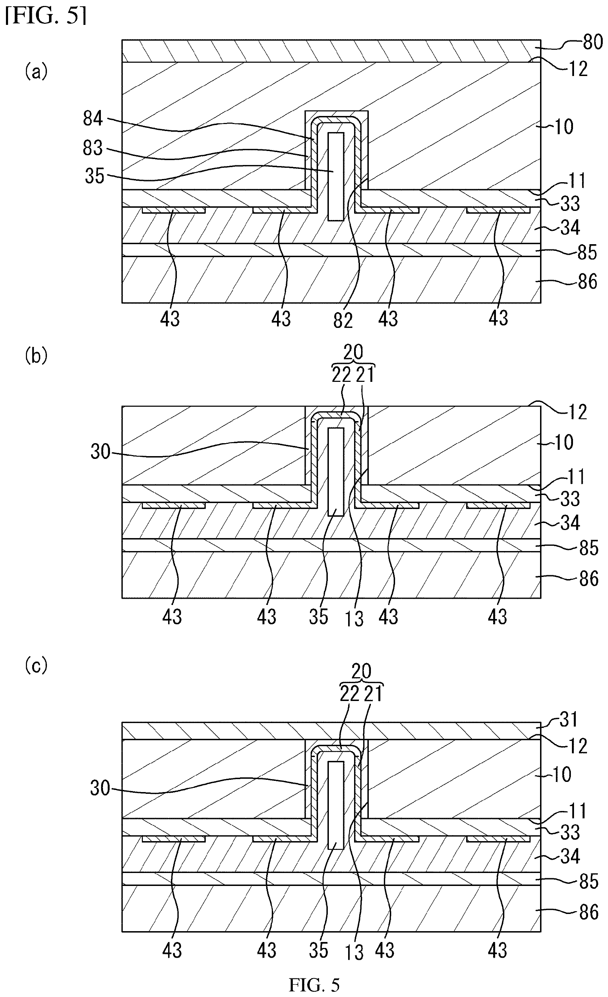

As illustrated in FIG. 5(a), the substrate 10 is turned upside down, and the insulating film 34 is bonded to a supporting substrate 86 by an adhesive 85. The supporting substrate 86 is, for example, a silicon substrate.

As illustrated in FIG. 5(b), the substrate 10 is thinned by grinding and polishing (for example, chemical mechanical polishing (CMP)) from a side of the second surface 12, and the thermal oxide film 83 formed on the bottom surface of the recess 82 is exposed. For example, the substrate 10 is thinned by grinding and polishing so that the substrate 10 of about several µm remains on the thermal oxide film 83 formed on the bottom surface of the recess 82, and then the substrate 10 is wet-etched by a KOH aqueous solution or the like to expose the thermal oxide film 83. As a result, the through hole 13 penetrating between the first surface 11 and the second surface 12 is formed in the substrate 10. The through electrode 20 is formed in the through hole 13. The through electrode 20 has the cylindrical side portion 21 composed of the conductive film 84 formed on the inner wall surface of the through hole 13, and the bottom portion 22 composed of the conductive film 84 connected to the side portion 21 and overlapping the inside of the cylindrical shape of the side portion 21. The insulating film 30 made of the thermal oxide film 83 is formed between the through electrode 20 and the inner wall surface of the through hole 13.

As illustrated in FIG. 5(c), the insulating film 31 made of a silicon oxide film is formed on the second surface 12 of the substrate 10 by, for example, the CVD method. The thickness of the insulating film 31 is 100 nm as an example.

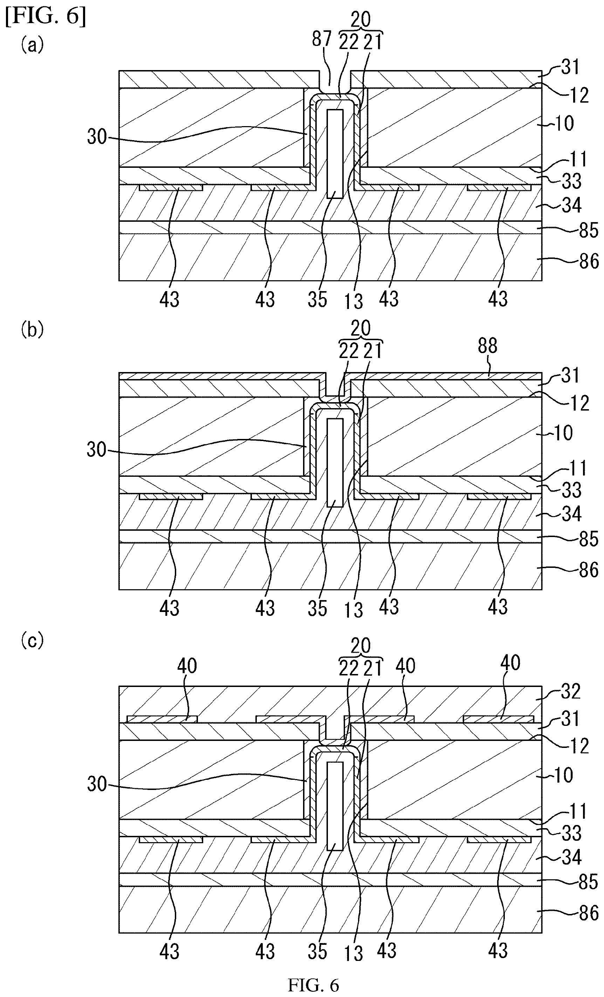

As illustrated in FIG. 6(a), an opening 87 through which the bottom 22 of the through electrode 20 is exposed is formed in the insulating film 31 and the insulating film 30 by the RIE using, for example, a fluorine-based gas.

As illustrated in FIG. 6(b), a conductive film 88 made of, for example, titanium nitride is formed on the second surface 12 of the substrate 10 by, for example, a sputtering method. The conductive film 88 is also formed in the opening 87 and is in contact with the bottom 22 of the through electrode 20. The thickness of the conductive film 88 is, for example, 100 nm. The conductive film 88 may be formed by the ALD method or the CVD method instead of the sputtering method.

As illustrated in FIG. 6(c), the conductive film 88 is patterned by the RIE using, for example, a chlorine-based gas. Thus, one or a plurality of first wiring patterns 40 made of the conductive film 88 are formed. The first wiring patterns 40 are formed on the second surface 12 of the substrate 10 through the insulating film 31. Then, the insulating film 32 made of a silicon oxide film is formed on the second surface 12 of the substrate 10 by, for example, the CVD method. The thickness of the insulating film 32 is 200 nm as an example. The insulating film 32 is formed on the insulating film 31 so as to cover the first wiring patterns 40.

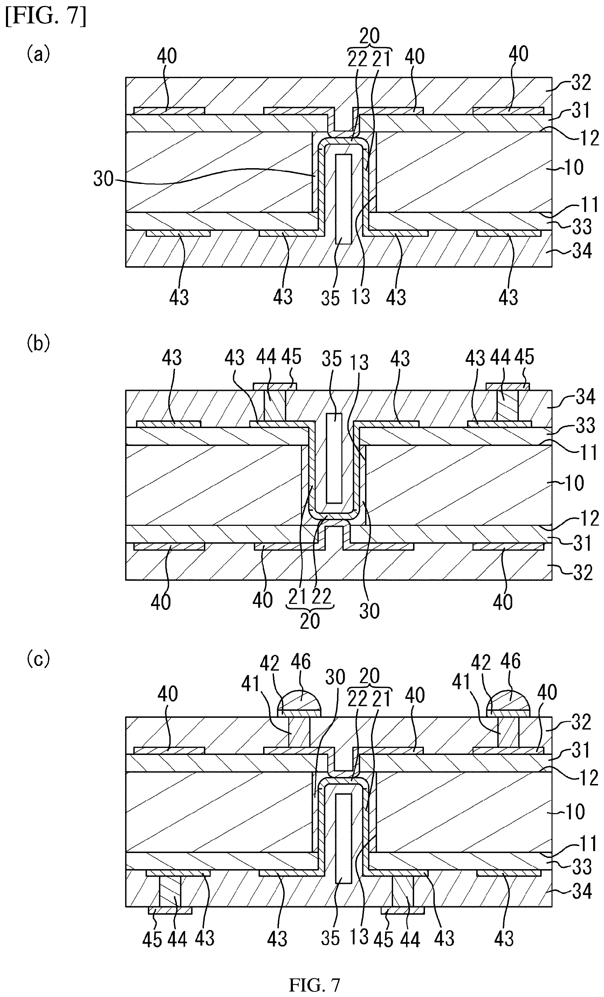

As illustrated in FIG. 7(a), the supporting substrate 86 is peeled off. For example, in the case where the adhesive 85 whose adhesive strength is reduced by ultraviolet irradiation is used, the supporting substrate 86 is peeled off by irradiating the adhesive 85 with ultraviolet rays.

As illustrated in FIG. 7(b), the substrate 10 is turned upside down, and openings for exposing the second wiring patterns 43 are formed in the insulating film 34 by the RIE using, for example, a fluorine-based gas. Thereafter, the through wirings 44 are formed by, for example, the sputtering method, so as to be embedded in the openings formed in the insulating film 34 and connected to the second wiring patterns 43. The second terminal electrode 45 connected to the through wirings 44 are formed on the insulating film 34 by, for example, the sputtering method and the etching method. The through wirings 44 and the second terminal electrodes 45 are not limited to be formed in separate steps, but may be formed simultaneously in the same step.

As illustrated in FIG. 7(c), the substrate 10 is turned upside down, and openings for exposing the first wiring patterns 40 are formed in the insulating film 32 by the RIE using, for example, a fluorine-based gas. Thereafter, the through wirings 41 are formed by, for example, the sputtering method, so as to be embedded in the openings formed in the insulating film 32 and connected to the first wiring patterns 40. The first terminal electrodes 42 connected to the through wirings 41 are formed on the insulating film 32 by, for example, the sputtering method and the etching method. The through wiring 41 and the first terminal electrode 42 are not limited to be formed in separate steps, but may be formed simultaneously in the same step. Thereafter, the bump electrodes 46 are formed on the first terminal electrodes 42. The device 100 according to the first embodiment is thus formed.

In FIGs. 7(b) and 7(c), the case where the through wirings 41 and the first terminal electrodes 42 are formed after the through wirings 44 and the second terminal electrodes 45 are formed is illustrated as an example, but the through wirings 41 and the first terminal electrodes 42 may be formed in a reverse order. In the case where the through wirings 41 and the first terminal electrodes 42 are formed first, the through wirings 41 and the first terminal electrodes 42 may be formed in a state where the supporting substrate 86 is joined to the insulating film 34 without being peeled off. The bump electrodes 46 may be formed on the second terminal electrodes 45 without being formed on the first terminal electrode 42, or may be formed on both the first terminal electrode 42 and the second terminal electrode 45, or need not be formed on both the first terminal electrode 42 and the second terminal electrode 45.

### [First Comparative Example]

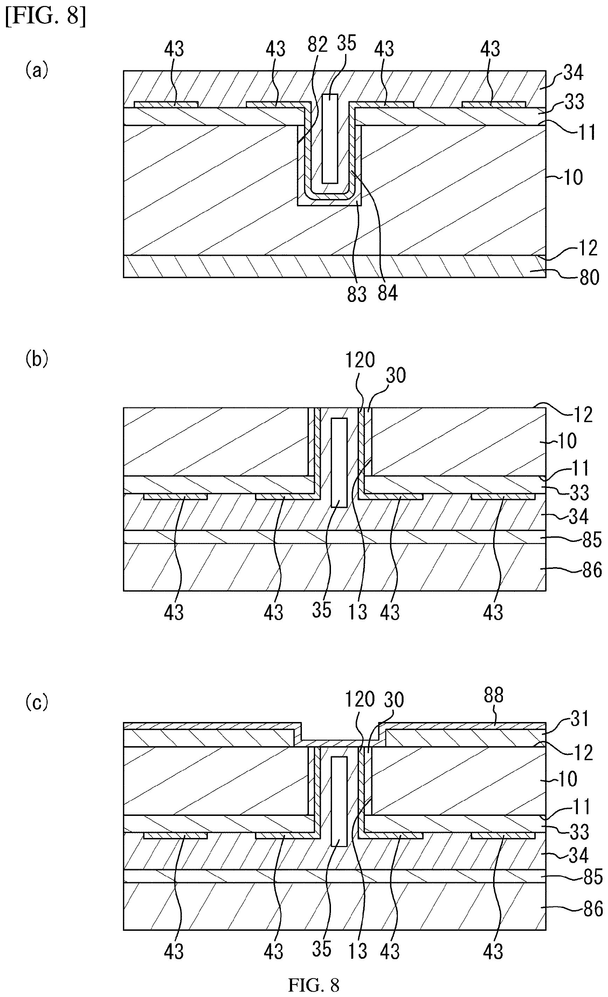

FIGs. 8(a) to 9(c) are cross-sectional views illustrating a method of manufacturing a device according to a first comparative example. First, the same manufacturing processes as those illustrated in FIGs. 3(a) to 4(c) of the first embodiment are carried out to obtain FIG. 8(a).

As illustrated in FIG. 8(b), the substrate 10 is turned upside down, and the insulating film 34 is bonded to the supporting substrate 86 by the adhesive 85. Thereafter, the substrate 10 is thinned by grinding and polishing from the side of the second surface 12, and the conductive film 84 is exposed from the second surface 12 of the substrate 10. As a result, the through hole 13 penetrating between the first surface 11 and the second surface 12 is formed in the substrate 10. A cylindrical through electrode 120 made of the conductive film 84 formed on the inner wall surface of the through hole 13 is formed in the through hole 13.

As illustrated in FIG. 8(c), after the insulating film 31 is formed on the second surface 12 of the substrate 10, an opening through which the through electrode 120 is exposed is formed in the insulating film 31. Thereafter, the conductive film 88 is formed on the second surface 12 of the substrate 10. The conductive film 88 is also formed in the opening of the insulating film 31 and is in contact with the through electrode 120.

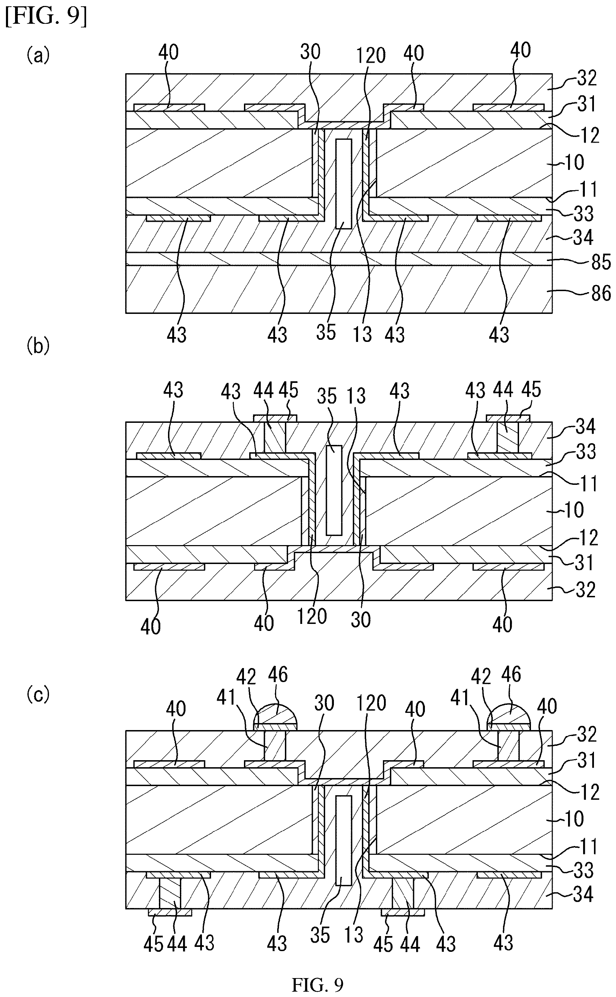

As illustrated in FIG. 9(a), the conductive film 88 is patterned to form the one or the plurality of first wiring patterns 40. Then, the insulating film 32 is formed on the second surface 12 of the substrate 10.

As illustrated in FIG. 9(b), after the supporting substrate 86 is peeled off, the through wirings 44 connected to the second wiring patterns 43 are formed in the insulating film 34. The second terminal electrodes 45 connected to the through wirings 44 are formed on the insulating film 34.

As illustrated in FIG. 9(c), the through wirings 41 connected to the first wiring patterns 40 are formed in the insulating film 32. The first terminal electrodes 42 connected to the through wirings 41 are formed on the insulating film 32. Thereafter, the bump electrodes 46 are formed on the first terminal electrodes 42. Thus, the device according to the first comparative example is formed.

In the first comparative example, the through electrode 120 formed in the through hole 13 of the substrate 10 is formed in a cylindrical shape along the inner wall surface of the through hole 13. For example, when the through electrode is formed so as to fill the through hole, the substrate and/or the through electrode may be damaged due to a difference in linear expansion coefficient between the substrate and the through electrode. However, in the first comparative example, since the through electrode 120 is in a cylindrical shape along the inner wall surface of the through hole, the damage to the substrate 10 and the through electrode 120 due to the difference in linear expansion coefficient between the substrate 10 and the through electrode 120 is suppressed. However, in the first comparative example, since the through electrode 120 is cylindrical, the connection area between the first wiring pattern 40 and the through electrode 120 is reduced. This may cause instability of the contact between the first wiring pattern 40 and the through electrode 120, and may cause an increase and/or a fluctuation in the electric resistance. For example, when the through electrode 120 is formed in the through hole 13 having a large aspect ratio, the through electrode 120 is preferably formed by the ALD method, but in this case, the through electrode 120 is formed in a cylindrical shape with a small thickness along the inner wall surface of the through hole 13. Therefore, the connection area between the first wiring pattern 40 and the through electrode 120 is reduced. In the case where the through electrode 120 is formed by the sputtering method or the CVD method, the conductive film 84 in the vicinity of the bottom surface of the recess 82 is thin, and therefore, even in this case, the connection area between the first wiring pattern 40 and the through electrode 120 is reduced.

On the other hand, according to the first embodiment, as illustrated in FIG. 1, the through electrode 20 has the side portion 21 along the inner wall surface of the through hole 13 and the bottom portion 22 connected to the side portion 21. The first wiring pattern 40 is connected to the bottom portion 22 of the through electrode 20. In this way, the connection area between the first wiring pattern 40 and the through electrode 20 can be increased by connecting the first wiring pattern 40 to the bottom portion 22. Therefore, an increase and a fluctuation in the electric resistance between the first wiring pattern 40 and the through electrode 20 can be suppressed. As illustrated in FIG. 1, the insulating film 34 (protective film) is provided closer to the center of the through hole 13 than the through electrode 20. Thus, the through electrode 20 is not exposed to the outside, and hence the through electrode 20 can be prevented from being deteriorated. In addition, it is possible to suppress the occurrence of unintended conduction in the through electrode 20.

In addition, in the first embodiment, as illustrated in FIG. 2(b), the first wiring pattern 40 is connected to a region of a half or more of the surface near the first wiring pattern 40 of the bottom portion 22. This increases the connection area between the first wiring pattern 40 and the through electrode 20, and thus can reduce the electrical resistance between the first wiring pattern 40 and the through electrode 20. From the viewpoint of increasing the connection area, the first wiring pattern 40 is preferably connected to a region of 60% or more of the surface near the first wiring pattern 40 of the bottom portion 22, more preferably connected to a region of 70% or more, and still more preferably connected to a region of 80% or more.

In addition, in the first embodiment, the linear expansion coefficient of the insulating film 34 provided closer to the center of the through hole 13 than the through electrode 20 is closer to the linear expansion coefficient of the substrate 10 than the linear expansion coefficient of the through electrode 20. Thus, a stress generated in the substrate 10 and/or the through electrode 20 due to the difference in the linear expansion coefficient between the substrate 10 and the through electrode 20 is relaxed by the insulating film 34, and therefore, the damage generated in the substrate 10 and the through electrode 20 can be suppressed. As an example of a case where the linear expansion coefficient of the insulating film 34 is closer to that of the substrate 10 than to that of the through electrode 20, a case where the substrate 10 is a silicon substrate, a glass substrate, or a quartz substrate and the insulating film 34 is a silicon oxide film or polysilicon can be cited. In this case, the effect of improving the ease of manufacturing the device 100 can also be obtained.

In addition, in the first embodiment, as illustrated in FIG. 1, the second wiring patterns 43 formed of the same material as the through electrode 20 are provided on the first surface 11 of the substrate 10 in connection with the through electrode 20. The first terminal electrodes 42 connected to the first wiring patterns 40 are provided on the second surface 12 of the substrate 10, and the second terminal electrodes 45 connected to the second wiring patterns 43 are provided on the first surface 11. This allows the device 100 of the first embodiment to be used as an interposer. Since the second wiring patterns 43 are formed of the same material as that of the through electrode 20, the second wiring patterns 43 and the through electrode 20 can be formed by a single film forming process. Accordingly, the number of manufacturing steps can be reduced, and the energy and resources used in manufacturing can be reduced.

In the first embodiment, as illustrated in FIG. 1, the cavity 35 is formed inside the insulating film 34 of the through hole 13. In this case, since the through electrode 20 is suppressed from being exposed to the outside, it is possible to suppress the deterioration of the through electrode 20 and the occurrence of unintended conduction in the through electrode 20.

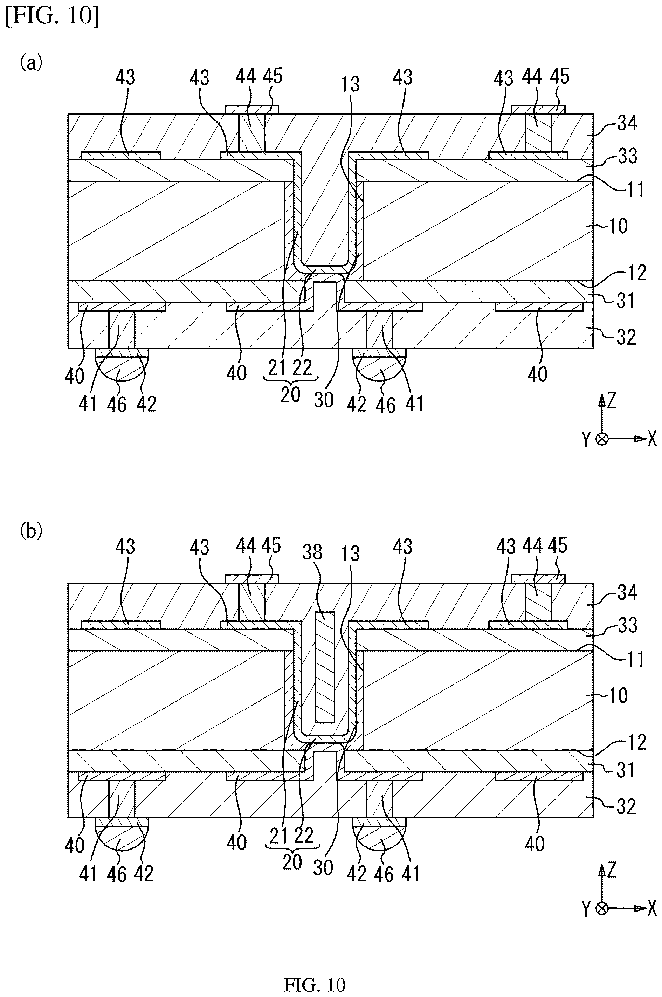

Although the first embodiment has been described with reference to the case where the cavity 35 is formed inside the insulating film 34 of the through hole 13, the cavity 35 need not be formed. FIGs. 10(a) and 10(b) are cross-sectional views illustrating an example in which no cavity is formed in the through hole in the first embodiment. As illustrated in FIG. 10(a), the through hole 13 may be filled with the insulating film 34 on the inside of the through electrode 20. As illustrated in FIG. 10(b), the through hole 13 may be filled with the insulating film 34 and another film 38 other than the insulating film 34 on the inside of the through electrode 20. In these cases, it is also possible to suppress the deterioration of the through electrode 20 and the occurrence of unintended conduction in the through electrode 20. It is preferable that the linear expansion coefficient of the another film 38 is closer to the linear expansion coefficient of the substrate 10 than the linear expansion coefficient of the through electrode 20.

In the first embodiment, the through electrode 20, the first wiring patterns 40, and the second wiring patterns 43 are formed of titanium nitride. Since the through electrode 20, the first wiring patterns 40, and the second wiring patterns 43 are formed of the superconducting material, the device 100 can be used as the interposer on which the quantum bit chip is mounted.

According to the first embodiment, as illustrated in FIG. 5(b), the through electrode 20 having the side portion 21 along the inner wall surface of the through hole 13 and the bottom portion 22 connected to the side portion 21 is formed in the through hole 13 of the substrate 10. The insulating film (protection film) 34 is formed closer to the center of the through hole 13 than the through electrode 20. As illustrated in FIG. 6(c), the first wiring pattern 40 connected to the bottom 22 of the through electrode 20 is formed on the second surface 12 of the substrate 10. This makes it possible to increase the connection area between the first wiring pattern 40 and the through electrode 20, and to suppress the increase and the fluctuation in the electrical resistance between the first wiring pattern 40 and the through electrode 20.

In the first embodiment, as illustrated in FIG. 4(a), the conductive film 84 is formed along the inner surface of the recess 82 in the recess 82 formed in the first surface 11 of the substrate 10. As illustrated in FIG. 5(b), the thickness of the substrate 10 is reduced from the side of the second surface 12 of the substrate 10. Thus, the through electrode 20 having the side portion 21 formed of the conductive film 84 along the inner wall surface of the through hole 13 and the bottom portion 22 formed of the conductive film 84 connected to the side portion 21 is formed. According to this manufacturing method, the through electrode 20 having the side portion 21 along the inner wall surface of the through hole 13 and the bottom portion 22 connected to the side portion 21 can be easily formed.

In the first embodiment, the conductive film 84 along the inner surface of the recess 82 is deposited by the ALD method. Thus, even when the aspect ratio of the recess 82 is large, the conductive film 84 having a uniform thickness can be formed on the inner surface of the recess 82.

In the first embodiment, as illustrated in FIG. 4(b), the conductive film 84 extending from the inner surface of the recess 82 to the first surface 11 of the substrate 10 is patterned, thereby forming the second wiring patterns 43 connected to the through electrode 20 on the first surface 11. This allows the through electrode 20 and the second wiring patterns 43 to be formed by a single film formation process, thereby reducing the number of manufacturing steps. Therefore, the energy and resources used in the manufacturing process can be reduced.

Although the first wiring pattern 40 is used as a first wiring connected to the bottom 22 of the through electrode 20 in the first embodiment, the first wiring pattern 40 is not limited to this case, and may be, for example, a through wiring embedded in an opening of the insulating film 31. Alternatively, the wiring structure may be a multilayer wiring structure in which one or a plurality of wiring layers are provided on the insulating film 34 on the first surface 11 of the substrate 10 and/or one or a plurality of wiring layers are provided on the insulating film 32 on the second surface 12 of the substrate 10.

### [Second Embodiment]

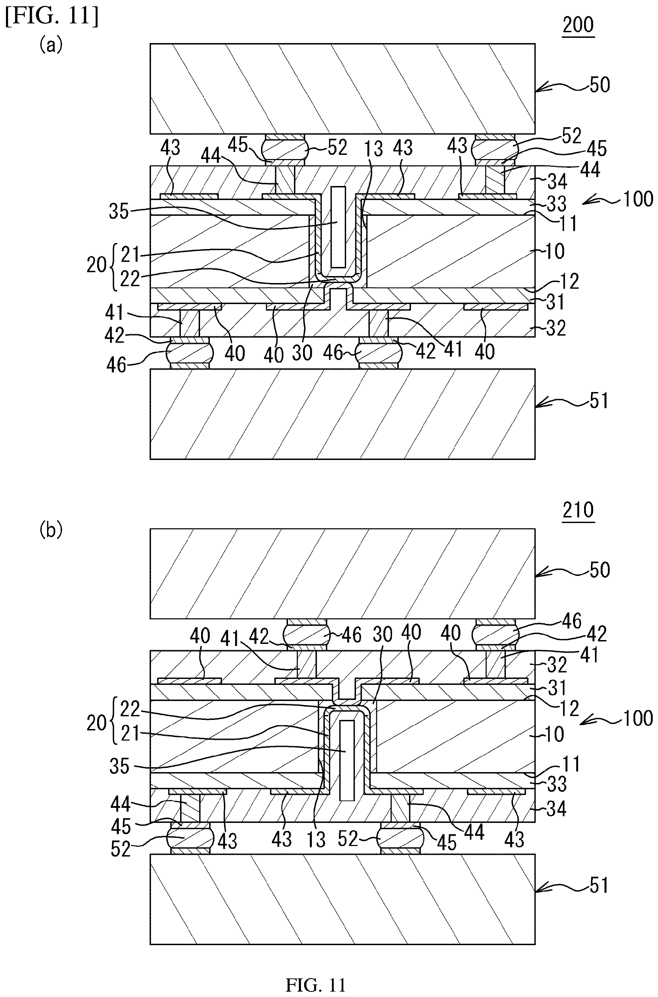

FIG. 11(a) is a cross-sectional view of a device according to a second embodiment, and FIG. 11(b) is a cross-sectional view of a device according to a modification of the second embodiment. As illustrated in FIG. 11(a), in a device 200 according to the second embodiment, a quantum bit chip 50 is flip-chip mounted on the first surface 11 of the substrate 10 constituting the device 100. The quantum bit chip 50 is bonded to the second terminal electrodes 45 by bump electrodes 52. Although not illustrated, a quantum bit element is formed in the quantum bit chip 50. A circuit chip 51 is flip-chip mounted on the second surface 12 of the substrate 10. The circuit chip 51 is bonded to the first terminal electrodes 42 by the bump electrodes 46. Although not illustrated, the circuit chip 51 is formed with an active element such as a CMOS element and/or a passive element such as a capacitor or an inductor.

As illustrated in FIG. 11(b), in a device 210 according to a modification of the second embodiment, the quantum bit chip 50 is flip-chip mounted on the second surface 12 of the substrate 10 constituting the device 100 by the bump electrodes 46. The circuit chip 51 is flip-chip mounted on the first surface 11 of the substrate 10 by the bump electrodes 52.

According to the second embodiment and the modification thereof, the quantum bit chip 50 is mounted on one of the first surface 11 and the second surface 12 of the substrate 10, and the circuit chip 51 is mounted on the other surface. In the device 100, the connection area between the first wiring pattern 40 and the through electrode 20 is increased, and the increase and the fluctuation in the electrical resistance between the first wiring pattern 40 and the through electrode 20 are suppressed. Therefore, by mounting the quantum bit chip 50 and the circuit chip 51 on the device 100, the increase and the fluctuation in the electric resistance between the quantum bit chip 50 and the circuit chip 51 are suppressed.

### [Third Embodiment]

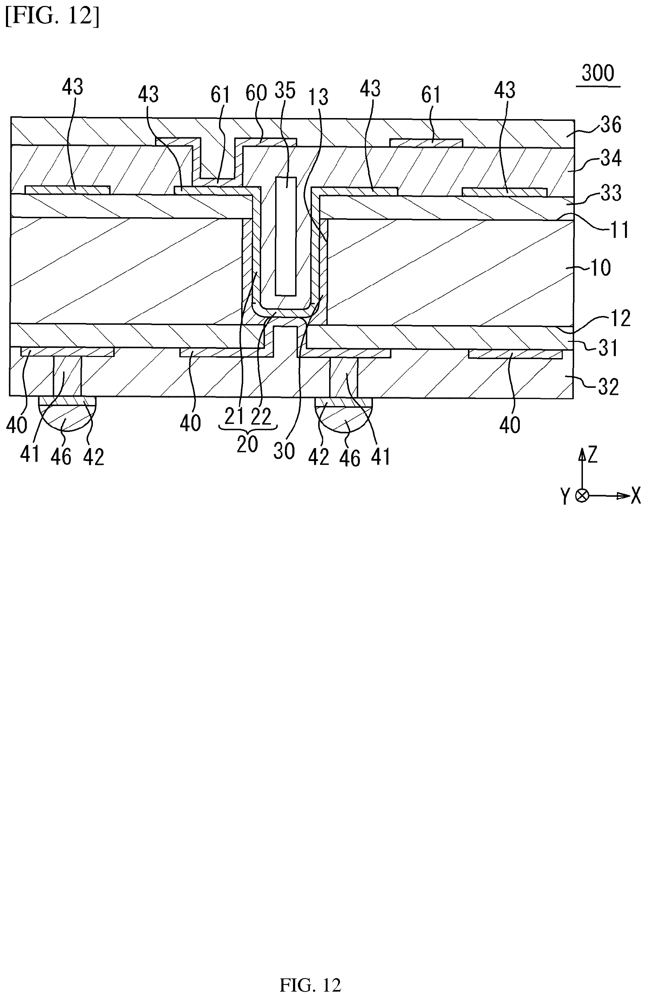

In a third embodiment, an example of a quantum bit device in which a quantum bit element is formed is illustrated. FIG. 12 is a cross-sectional view of a device according to the third embodiment. As illustrated in FIG. 12, a device 300 according to the third embodiment is provided with a quantum bit element 60 and one or a plurality of third wiring patterns 61 on the insulating film 34. The quantum bit element 60 is connected to the through electrode 20 through the third wiring pattern 61 and the second wiring pattern 43. An insulating film 36 covering the quantum bit element 60 and the third wiring patterns 61 is provided on the insulating film 34. The insulating film 36 is, for example, a silicon oxide film, and has a thickness of, for example, 100 nm to 300 nm. The other configurations are the same as those of the first embodiment, and therefore, the description thereof is omitted.

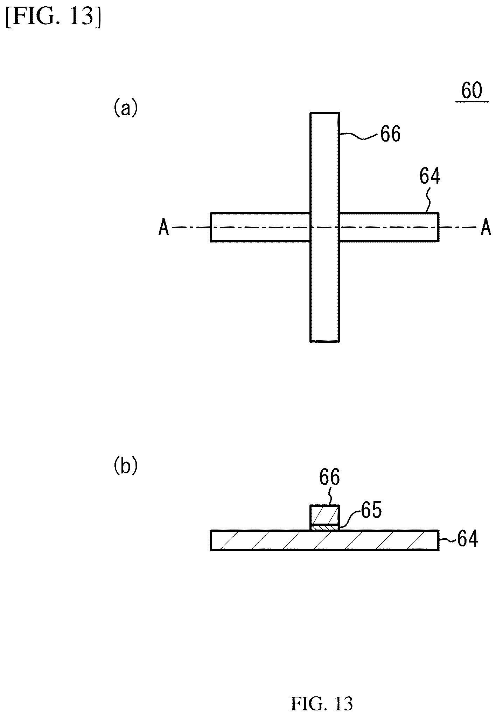

FIG. 13(a) is a plan view of a quantum bit element according to the third embodiment, and FIG. 13(b) is a cross-sectional view taken along the line A-A in FIG. 13(a). As illustrated in FIGs. 13(a) and 13(b), the quantum bit element 60 is a Josephson junction element having a lower superconducting film 64, an insulating film 65, and an upper superconducting film 66. The lower superconducting film 64 and the upper superconducting film 66 extend to intersect with each other. The insulating film 65 is provided between the lower superconducting film 64 and the upper superconducting film 66 at least at a location where the lower superconducting film 64 and the upper superconducting film 66 intersect with each other. The lower superconducting film 64 and the upper superconducting film 66 are formed of a superconducting material such as aluminum. The insulating film 65 is formed of, for example, aluminum oxide.

### [Manufacturing Method]

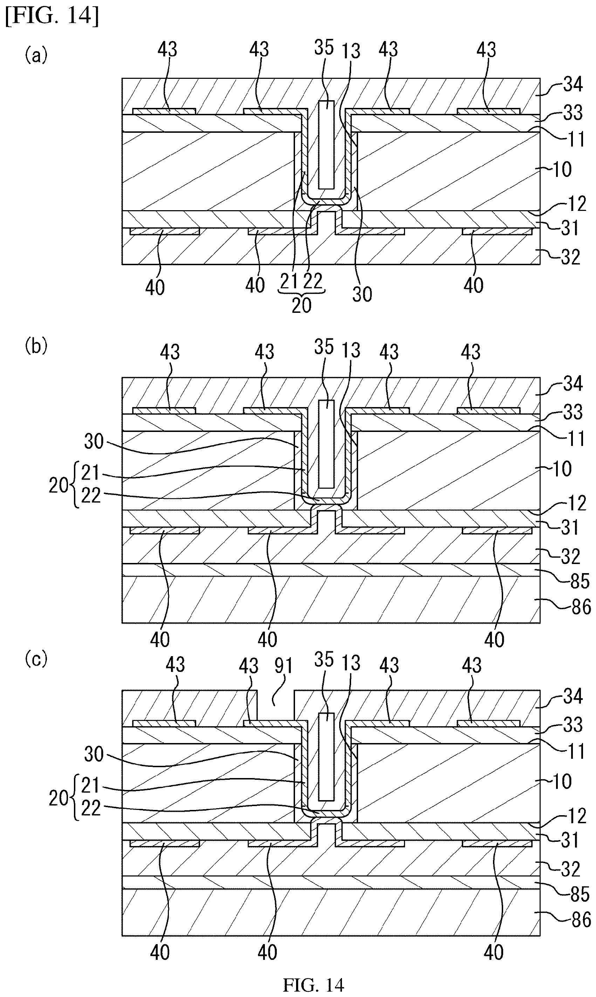

FIGs. 14(a) to 15(c) are cross-sectional views illustrating a method of manufacturing a device according to the third embodiment. First, the same manufacturing process as that illustrated in FIGs. 3(a) to 7(a) of the first embodiment is carried out to obtain FIG. 14(a).

As illustrated in FIG. 14(b), the insulating film 32 is bonded to the supporting substrate 86 by the adhesive 85.

As illustrated in FIG. 14(c), a mask layer (not illustrated) formed on the insulating film 34 is used as a mask to form an opening 91 for exposing the second wiring pattern 43 in the insulating film 34 by the RIE using, for example, a fluorine-based gas.

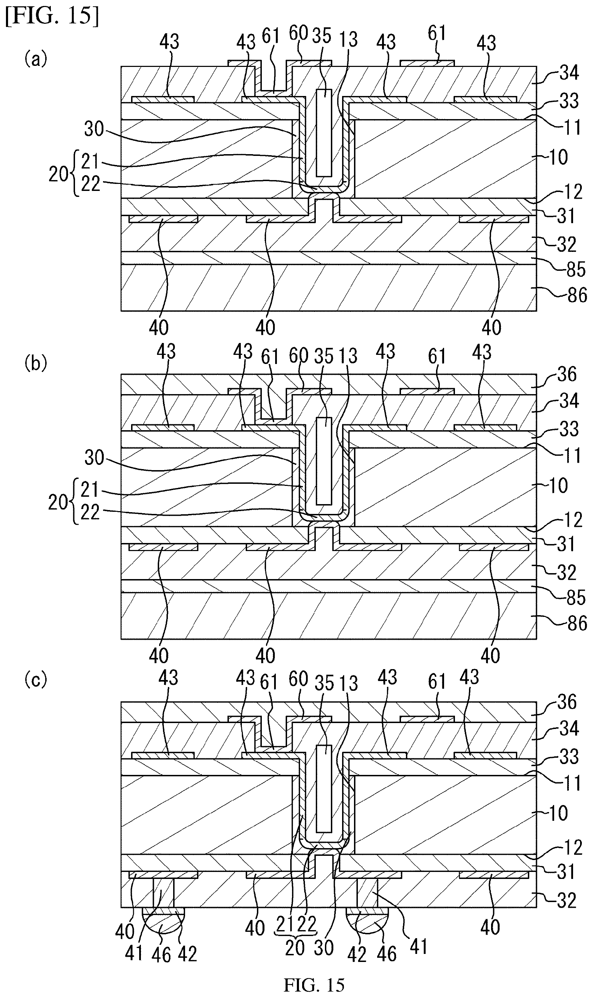

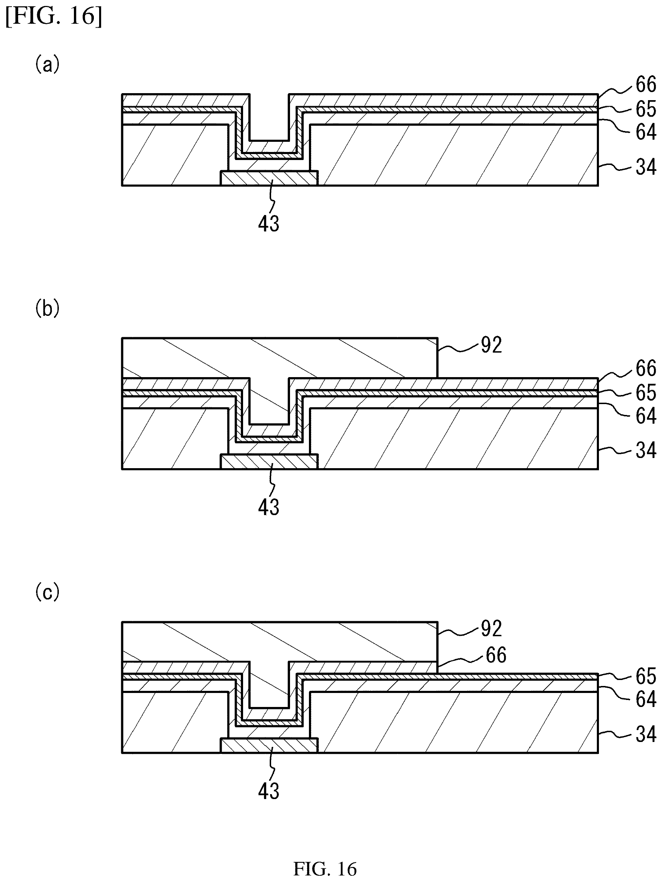

As illustrated in FIG. 15(a), the quantum bit element 60 and the one or the plurality of third wiring patterns 61 are formed on the insulating film 34. The quantum bit element 60 is connected to the second wiring pattern 43 through the third wiring pattern 61. The formation of the quantum bit element 60 and the third wiring pattern 61 will be described with reference to FIGs. 16(a) to 17(c).

FIGs. 16(a) to 17(c) are cross-sectional views illustrating a method of manufacturing the quantum bit element and the third wiring pattern according to the third embodiment. As illustrated in FIG. 16(a), the lower superconducting film 64 is formed on the insulating film 34 by, for example, a vapor deposition method. The insulating film 65 is formed on the lower superconducting film 64 by, for example, the ALD method. The upper superconducting film 66 is formed on the insulating film 65 by, for example, the vapor deposition method.

As illustrated in FIG. 16(b), a mask layer 92 which is, for example, a silicon oxide film is formed on the upper superconducting film 66 by, for example, the CVD method. Thereafter, the mask layer 92 is patterned.

As illustrated in FIG. 16(c), the mask layer 92 is used as a mask to etch the upper superconducting film 66 by the RIE using, for example, a chlorine-based gas.

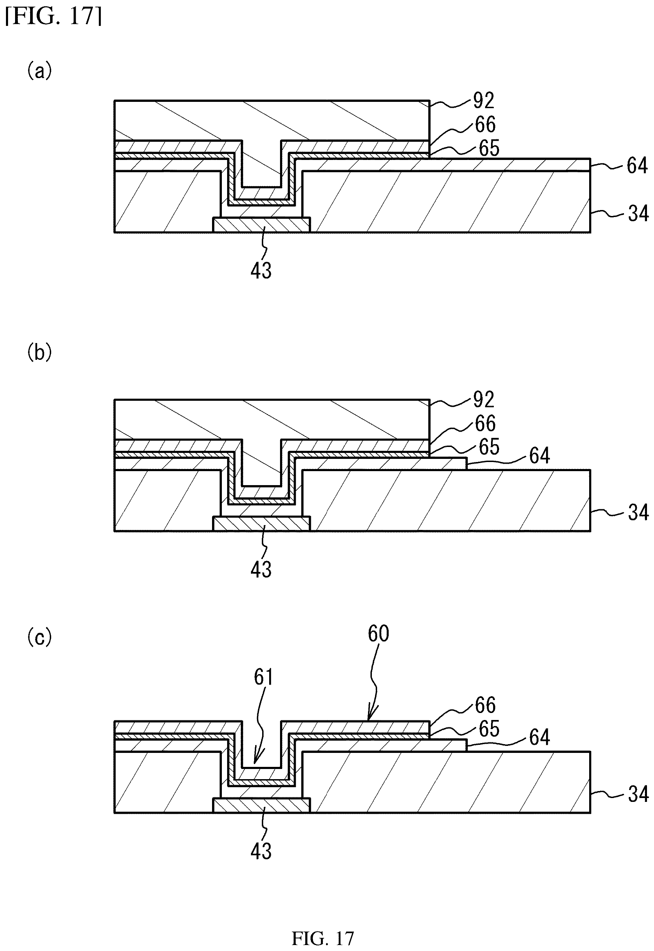

As illustrated in FIG. 17(a), the mask layer 92 is used as a mask to etch the insulating film 65 by using, for example, a milling method.

As illustrated in FIG. 17(b), the mask layer 92 is used as a mask to etch the lower superconducting film 64 by the RIE using, for example, a chlorine-based gas.

As illustrated in FIG. 17(c), the mask layer 92 is removed. As a result, the quantum bit element 60 is formed by the lower superconducting film 64, the insulating film 65, and the upper superconducting film 66. The third wiring pattern 61 is also formed by the lower superconducting film 64, the insulating film 65, and the upper superconducting film 66. The quantum bit element 60 is connected to the second wiring pattern 43 through the third wiring pattern 61.

As illustrated in FIG. 15(b), the insulating film 36 made of a silicon oxide film is formed on the insulating film 34 by, for example, the CVD method. The thickness of the insulating film 36 is 200 nm as an example. The insulating film 36 is formed on the insulating film 34 so as to cover the quantum bit element 60 and the third wiring patterns 61.

As illustrated in FIG. 15(c), after the supporting substrate 86 is peeled off, the through wirings 41 are formed in the insulating film 32 by the same method as that of FIG. 7(c) of the first embodiment, and the first terminal electrodes 42 are formed on the through wirings 41. The bump electrodes 46 are formed on the first terminal electrodes 42. Thus, the device 300 according to the third embodiment is formed.

### [Modification]

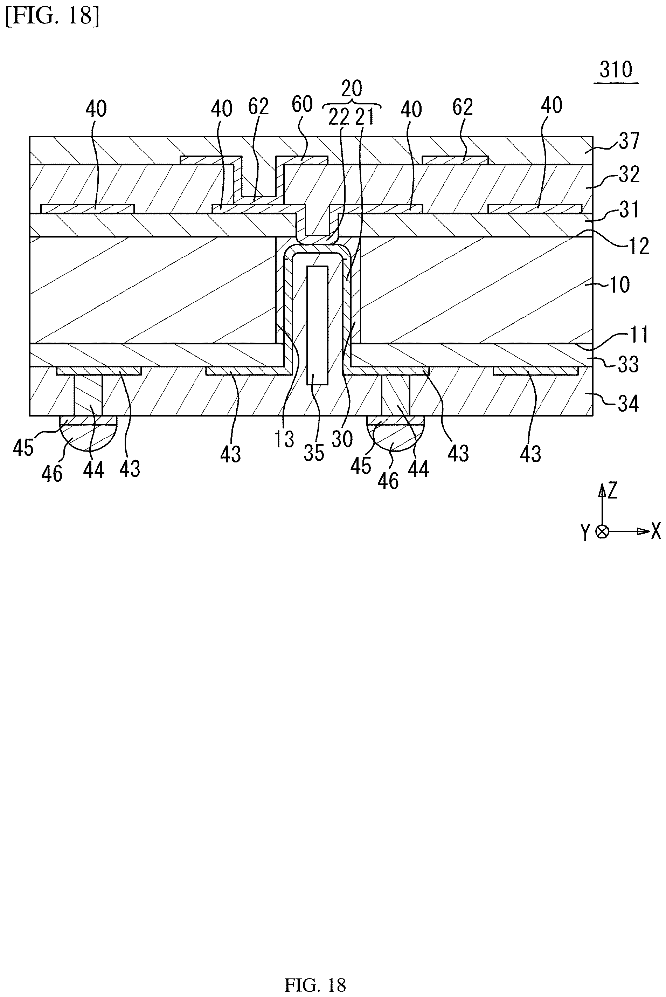

FIG. 18 is a cross-sectional view of a device according to a modification of the third embodiment. As illustrated in FIG. 18, in a device 310 according to the modification of the third embodiment, the quantum bit element 60 and one or a plurality of fourth wiring patterns 62 are provided on the insulating film 32. The quantum bit element 60 is connected to the through electrode 20 through the fourth wiring pattern 62 and the first wiring pattern 40. An insulating film 37 covering the quantum bit element 60 and the fourth wiring patterns 62 is provided on the insulating film 32. The insulating film 37 is, for example, a silicon oxide film, and has a thickness of, for example, 100 nm to 300 nm. The other configurations are the same as those of the first embodiment, and therefore, the description thereof is omitted.

### [Manufacturing Method]

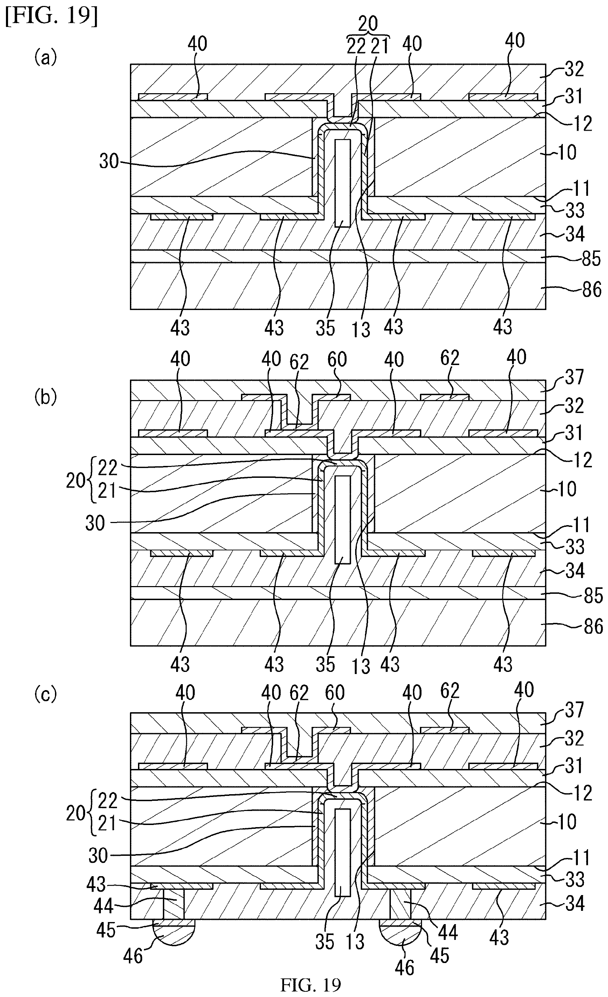

FIGs. 19(a) to 19(c) are cross-sectional views illustrating a method of manufacturing a device according to a modification of the third embodiment. First, the same manufacturing process as that illustrated in FIGs. 3(a) to 6(c) of the first embodiment is carried out to obtain FIG. 19(a).

As illustrated in FIG. 19(b), a mask layer (not illustrated) formed on the insulating film 32 is used as a mask to form an opening for exposing the first wiring pattern 40 in the insulating film 32 by the RIE using, for example, a fluorine-based gas. Then, the quantum bit element 60 and the one or the plurality of fourth wiring patterns 62 are formed on the insulating film 32. The quantum bit element 60 is connected to the first wiring pattern 40 through the fourth wiring pattern 62. The quantum bit element 60 and the fourth wiring patterns 62 are formed by the same method as that illustrated in FIGs. 16(a) to 17(c). Then, the insulating film 37 made of a silicon oxide film is formed on the insulating film 32 by, for example, the CVD method. The thickness of the insulating film 37 is, for example, 200 nm. The insulating film 37 is formed on the insulating film 32 so as to cover the quantum bit element 60 and the fourth wiring patterns 62.

As illustrated in FIG. 19(c), after the supporting substrate 86 is peeled off, the through wirings 44 are formed in the insulating film 34 by the same method as that of FIG. 7(b) of the first embodiment, and the second terminal electrodes 45 are formed on the through wirings 44. The bump electrodes 46 are formed on the surfaces of the second terminal electrodes 45. Thus, the device 310 according to the modification of the third embodiment is formed.

### [Second Comparative Example]

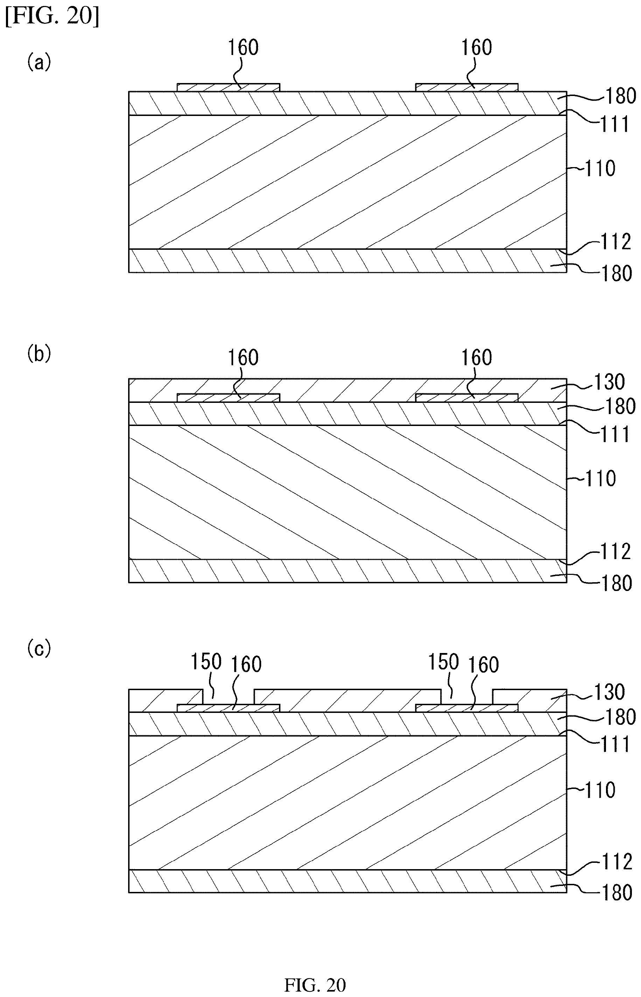

FIGs. 20(a) to 21(c) are cross-sectional views illustrating a method of manufacturing a device according to a second comparative example. As illustrated in FIG. 20(a), the substrate 110 is heated in an oxidizing atmosphere to form a thermal oxide film 180 on a first surface 111 and a second surface 112 of a substrate 110. Next, quantum bit elements 160 are formed on the thermal oxide film 180 formed on the first surface 111 of the substrate 110.

As illustrated in FIG. 20(b), an insulating film 130 which is a silicon oxide film is formed on the first surface 111 of the substrate 110 by, for example, the CVD method. The insulating film 130 is formed on the thermal oxide film 180 to cover the quantum bit elements 160.

As illustrated in FIG. 20(c), openings 150 for exposing the quantum bit elements 160 are formed in the insulating film 130 by the RIE using, for example, a fluorine-based gas.

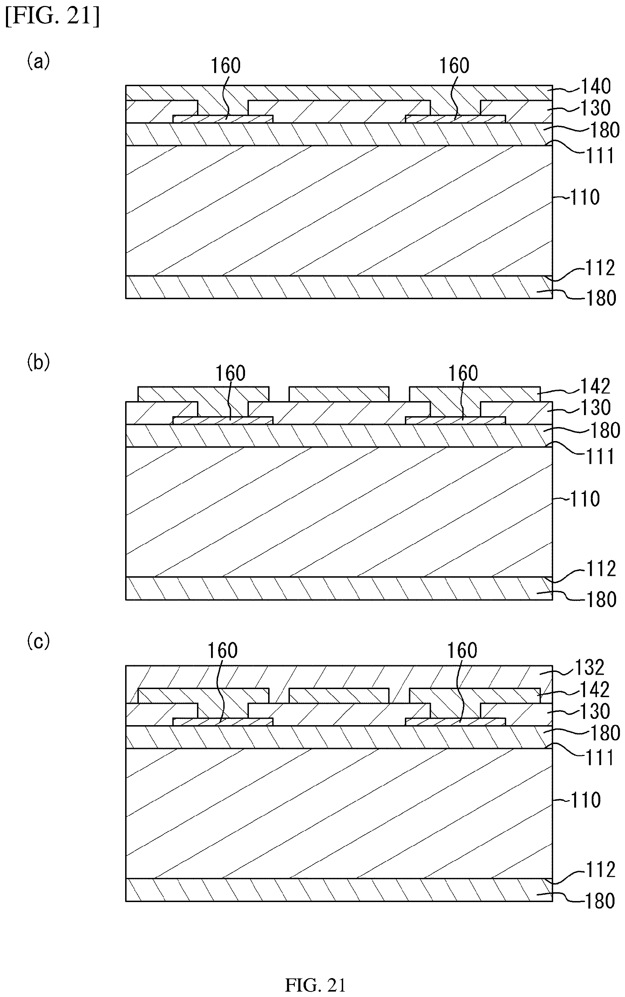

As illustrated in FIG. 21(a), a conductive film 140 is formed on the first surface 111 of the substrate 110 by, for example, the sputtering method. The conductive film 140 is also formed so as to be embedded in the openings 150 formed in the insulating film 130. The conductive film 140 is formed of, for example, titanium nitride.

As illustrated in FIG. 21(b), the conductive film 140 is patterned by the RIE using, for example, a chlorine-based gas to form one or a plurality of wiring patterns 142. A part of the one or the plurality of wiring patterns 142 is connected to the quantum bit element 160.

As illustrated in FIG. 21(c), an insulating film 132 which is a silicon oxide film is formed on the first surface 111 of the substrate 110 by, for example, the CVD method. The insulating film 132 is formed on the insulating film 130 to cover the wiring patterns 142.

In the case of forming a multilayer wiring structure in which a plurality of wiring patterns are laminated, the steps illustrated in FIGs. 20(b) to 21(c) are repeated.

According to the second comparative example, as illustrated in FIGs. 20(a) to 21(c), after the quantum bit elements 160 are formed, the insulating film 130 is formed and processed, the conductive film 140 is formed and processed, and the insulating film 132 is formed. The insulating films 130 and 132 are formed by, for example, the CVD method. In the film formation by the CVD method, the temperature of the substrate 110 becomes several hundred degrees centigrade, and therefore, the quantum bit elements 160 may be damaged. The conductive film 140 is formed by, for example, the sputtering method, and the insulating film 130 and the conductive film 140 are processed by, for example, the RIE. In the sputtering method and the RIE, since the insulating films 130 and 132 or the conductive film 140 are irradiated with charged particles, the quantum bit elements 160 may be also damaged. From these facts, it is considered that the characteristics of the quantum bit elements 160 deteriorate.

On the other hand, in the third embodiment, as illustrated in FIG. 12, the quantum bit element 60 connected to the second wiring pattern 43 is provided on a side opposite to the substrate 10 with respect to the second wiring pattern 43. In the modification of the third embodiment, as illustrated in FIG. 18, the quantum bit element 60 connected to the first wiring pattern 40 is provided on a side opposite to the substrate 10 with respect to the first wiring pattern 40. In the third embodiment, as illustrated in FIGs. 14(a) to 15(a), the quantum bit element 60 is formed after the second wiring patterns 43 are formed In the modification of the third embodiment, as illustrated in FIGs. 19(a) and 19(b), the quantum bit element 60 is formed after the first wiring patterns 40 are formed. In this way, the quantum bit element 60 is formed after the first wiring patterns 40 or the second wiring patterns 43, so that the damage to the quantum bit element 60 can be reduced. Therefore, the characteristic deterioration of the quantum bit element 60 can be suppressed, and the operation of the quantum bit element 60 can be stabilized. In order to suppress the characteristic deterioration of the quantum bit element 60, it is preferable that the quantum bit element 60 is formed after both the first wiring patterns 40 and the second wiring patterns 43 are formed.

In the third embodiment and the modification thereof, the wiring layer formed closer to the substrate 10 than the quantum bit element 60 may have a multilayer wiring structure. The quantum bit element 60 is preferably formed after all the wiring patterns of the plurality of wiring layers formed on the substrate 10. By forming the quantum bit element 60 after all the wiring patterns, the damage to the quantum bit element 60 can be reduced, and the temperature of the annealing process in the wiring process can be increased.

### [Fourth Embodiment]

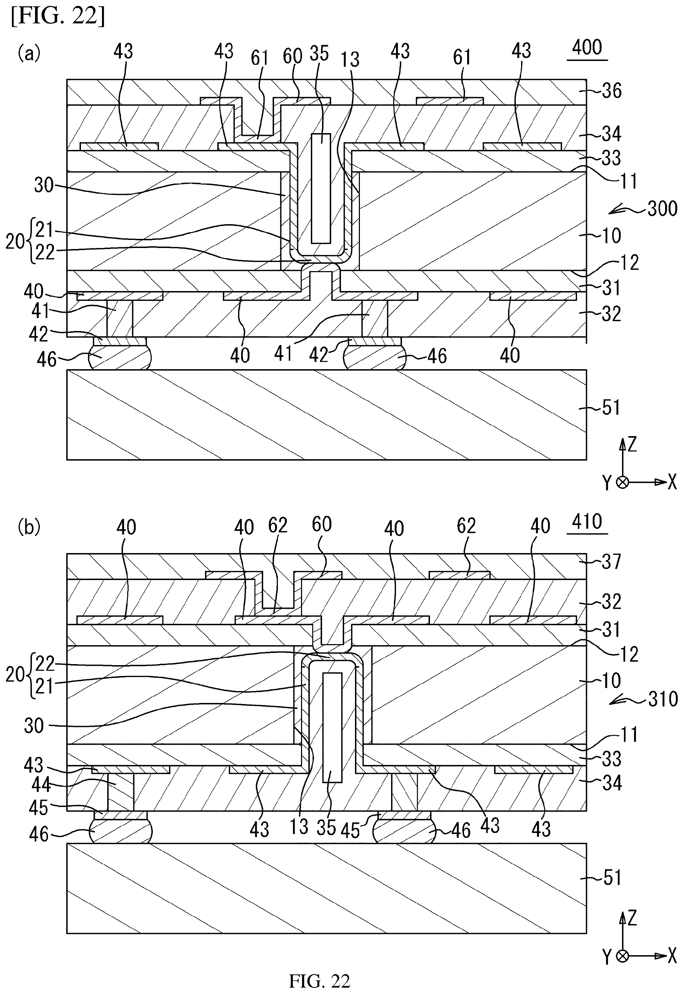

FIG. 22(a) is a cross-sectional view of a device according to a fourth embodiment, and FIG. 22 (b) is a cross-sectional view of a device according to a modification of the fourth embodiment. As illustrated in FIG. 22(a), in a device 400 according to the fourth embodiment, the circuit chip 51 is flip-chip mounted on the second surface 12 of the substrate 10 constituting the device 300 by the bump electrodes 46. As illustrated in FIG. 22(b), in a device 410 according to the modification of the fourth embodiment, the circuit chip 51 is flip-chip mounted on the first surface 11 of the substrate 10 constituting the device 310 by the bump electrodes 46.

According to the fourth embodiment and the modification thereof, the increase and the fluctuation in the electric resistance between the quantum bit element 60 and the circuit chip 51 are suppressed.

Although the embodiments of the present invention have been described in detail, the present invention is not limited to the specific embodiments, and various modifications and changes can be made within the scope of the gist of the present invention described in the claims.

### [Reference Signs List]

10... substrate, 11... first surface, 12. second surface, 13... through hole, 20, 20a... through electrode, 21... side portion, 22... bottom portion, 30, 31, 32, 33, 34... insulating film, 35... cavity, 36... insulating film, 37... insulating film, 38. other film, 40... first wiring pattern, 41... through wiring, 42... first terminal electrode, 43... second wiring pattern, 44... through wiring, 45... second terminal electrode, 46... bump electrode, 50... quantum bit chip, 51... circuit chip, 52... bump electrode, 60... quantum bit element, 61... third wiring pattern, 62... fourth wiring pattern, 64... lower layer superconducting film, 65... insulating film, 66... upper layer superconducting film, 80... thermal oxide film, 81... resist film, 82... recess, 83... thermal oxide film, 84... conductive film, 85... adhesive, 86... supporting substrate, 87... opening, 88... conductive film, 91... opening, 92... mask layer, 100... device, 110... substrate, 111... first surface, 112... second surface, 120... through electrode, 130, 132... insulating film, 140... conductive film, 142... wiring pattern, 150... opening, 160... quantum bit element, 180... thermal oxide film, 200, 300, 310, 400, 410... device

## Claims

1. A device comprising:
a substrate including a first surface, a second surface opposite to the first surface, and a through hole penetrating between the first surface and the second surface;
a through electrode provided in the through hole, the through electrode having a side portion along an inner wall surface of the through hole and a bottom portion connected to the side portion;
a protective film provided closer to a center of the through electrode than the through hole; and
a first wiring provided on the second surface of the substrate and connected to the bottom portion of the through electrode.

2. The device according to claim 1, wherein
the first wiring is connected to a region of a half or more of a surface near the first wiring of the bottom portion.

3. The device according to claim 1 or 2, wherein
a linear expansion coefficient of the protective film is closer to a linear expansion coefficient of the substrate than a linear expansion coefficient of the through electrode.

4. The device according to claim 1 or 2, further comprising:
a second wiring provided on the first surface in connection with the through electrode and formed of a same material as the through electrode;
a first terminal electrode for external connection provided on the second surface in connection with the first wiring; and
a second terminal electrode for external connection provided on the first surface in connection with the second wiring.

5. The device according to claim 4, further comprising:
a quantum bit chip mounted on one of the first surface and the second surface; and
a circuit chip mounted on another of the first surface and the second surface.

6. The device according to claim 1 or 2, further comprising:
a second wiring provided on the first surface in connection with the through electrode and formed of a same material as the through electrode; and
a quantum bit element provided on a side opposite to the substrate with respect to one of the first wiring and the second wiring, and connected to the one of the first wiring and the second wiring.

7. The device according to claim 1 or 2, wherein
the through hole has a cavity inside the protective film.

8. The device according to claim 1 or 2, wherein
the protection film or the protection film and a film other than the protection film are embedded inside the through electrode of the through hole.

9. The device according to claim 1 or 2, wherein
the through electrode and the first wiring are formed of a superconducting material.

10. The device according to claim 1 or 2, wherein
the substrate is a silicon substrate, a glass substrate, or a quartz substrate, and the protective film is a silicon oxide film or polysilicon.

11. A method of manufacturing a device comprising:
a step of forming a through electrode in a through hole penetrating between a first surface of a substrate and a second surface opposite to the first surface, the through electrode having a side portion along an inner wall surface of the through hole and a bottom portion connected to the side portion;
a step of forming a protective film at a position closer to a center of the through electrode than the through hole; and
a step of forming a first wiring connected to the bottom of the through electrode on the second surface of the substrate.

12. The method of manufacturing the device according to claim 11, wherein
the step of forming the through electrode includes forming a conductive film along an inner surface of a recess in the recess formed in the first surface of the substrate, and then thinning the substrate from a side of the second surface of the substrate, thereby forming the through electrode having the side portion made of the conductive film along an inner wall surface of the through hole and the bottom portion made of the conductive film connected to the side portion.

13. The method of manufacturing the device according to claim 12, wherein
the step of forming the through electrode includes depositing the conductive film by an atomic layer deposition method to form the through electrode.

14. The method of manufacturing the device according to claim 12 or 13, further comprising:
a step of patterning the conductive film extending from the inner surface of the recess to the first surface of the substrate to form a second wiring on the first surface.

15. The method of manufacturing the device according to claim 11 or 12, further comprising:
a step of forming a quantum bit element connected to the first wiring on the second surface of the substrate after forming the first wiring.

16. The method of manufacturing the device according to claim 14, further comprising:
a step of forming a quantum bit element connected to the second wiring on the first surface of the substrate after forming the second wiring.
